(19) Europäisches Patentamt
European Patent Office
Office européen des brevets

(11) **EP 2 647 058 B1**

(12) **FASCICULE DE BREVET EUROPEEN**

(45) Date de publication et mention
de la délivrance du brevet:
**24.11.2021 Bulletin 2021/47**

(51) Int Cl.:
*H01L 31/05* (2014.01)    *H01L 31/048* (2014.01)
*H01L 23/26* (2006.01)    *G01M 3/22* (2006.01)
*G01M 3/38* (2006.01)

(21) Numéro de dépôt: **11793739.1**

(22) Date de dépôt: **02.12.2011**

(86) Numéro de dépôt international:
**PCT/EP2011/071615**

(87) Numéro de publication internationale:
**WO 2012/072792 (07.06.2012 Gazette 2012/23)**

(54) **MODULE PHOTOVOLTAÏQUE À DÉPRESSION CONTRÔLÉE, UTILISATION D'UN GETTER D'OXYGÈNE DANS UN MODULE PHOTOVOLTAÏQUE ET PROCÉDÉ DE FABRICATION D'UN TEL MODULE**

PV-MODUL MIT GESTEUERTEM VAKUUM, VERWENDUNG EINES SAUERSTOFFGETTERS IN EINEM PV-MODUL UND VERFAHREN ZUR HERSTELLUNG EINES DERARTIGEN MODULS

PHOTOVOLTAIC MODULE WITH A CONTROLLED VACUUM, USE OF AN OXYGEN GETTER IN A PHOTOVOLTAIC MODULE AND METHOD FOR MANUFACTURING SUCH A MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2010 FR 1060029**

(43) Date de publication de la demande:
**09.10.2013 Bulletin 2013/41**

(73) Titulaire: **YXENS**
**75013 Paris (FR)**

(72) Inventeurs:
• **SAINT-SERNIN, Etienne**
**F-69001 Lyon (FR)**
• **LAUVRAY, Hubert**
**F-92250 La Garenne Colombes (FR)**

(74) Mandataire: **Schmidt, Martin Peter**
**IXAS Conseil**
**22 avenue René Cassin**
**69009 Lyon (FR)**

(56) Documents cités:
EP-A1- 1 630 531    EP-A1- 2 461 369
EP-A1- 2 463 929    FR-A1- 2 862 427
US-A1- 2004 086 749    US-A1- 2010 148 127
US-A1- 2010 237 453

• TIPNIS R ET AL: "Large-area organic photovoltaic module-Fabrication and performance", SOLAR ENERGY MATERIALS AND SOLAR CELLS, ELSEVIER SCIENCE PUBLISHERS, AMSTERDAM, NL, vol. 93, no. 4, 1 April 2009 (2009-04-01), pages 442-446, XP025962301, ISSN: 0927-0248, DOI: 10.1016/J.SOLMAT.2008.11.018 [retrieved on 2009-01-08]
• ROLAND EINHAUS ET AL: "RECENT PROGRESS WITH APOLLONSOLAR'S NICE MODULE TECHNOLOGY", PROCEEDINGS OF THE 20TH EUROPEAN PHOTOVOLTAIC SOLAR ENERGY CONFERENCE, 6 June 2005 (2005-06-06), pages 1993-1996, XP040511862, Barcelona,Spain ISBN: 978-3-936338-19-5

EP 2 647 058 B1

**Description**

La présente invention concerne un module photovoltaïque à durée de vie prolongée ainsi que son procédé de fabrication.

Une des difficultés majeures rencontrées lors de la fabrication d'un module photovoltaïque est d'assurer son fonctionnement dans le temps.

Des technologies ont été récemment développées pour la fabrication de modules photovoltaïques sans contacts électriques soudés. WO-A-2004/095586 (ou FR 2 862 427 A1) décrit notamment un procédé de fabrication d'un module photovoltaïque pour lequel les contacts électriques sont obtenus par pression obtenue par l'instauration d'une dépression à l'intérieur du module. Le maintien de la dépression est un des éléments essentiels au bon fonctionnement de ce module. Même si toutes les précautions sont prises pour garantir l'étanchéité du module, la désorption de gaz ou des micro-fuites peuvent engendrer une hausse de la pression interne jusqu'à éventuellement entrainer une perte de contact électrique, le module s'en trouve ainsi dégradé. En effet, il existe une différence de pression entre l'extérieur et l'intérieur du module, les gaz ont alors tendance à passer de la zone dans laquelle leur pression partielle est la plus forte vers la zone dans laquelle leur pression partielle est la plus faible. Dans le cas des modules tels que ceux de WO-A-2004/095586 (ou FR 2 862 427 A1), pour lesquels le contact est obtenu par dépression, la pression à l'intérieur du module, et en particulier la pression partielle d'oxygène à l'intérieur du module, est plus faible que celle à l'extérieure du module. Ainsi, si l'étanchéité n'est pas totale, l'oxygène pénètre à l'intérieur du module, ce qui entraîne une augmentation de la pression interne et par conséquent une altération du fonctionnement et de la durée de vie du module. En effet, dans un mélange gazeux chaque gaz se comporte comme s'il était seul à occuper le volume entier. C'est-à-dire qu'il n'est pas influencé dans son comportement par la présence et la quantité des autres gaz. On définit alors la notion de pression partielle $P_i$ d'un gaz i comme :

$P_i = P \times n_i/n$ où P est la pression totale, n le nombre total de moles de gaz dans le volume considéré, et $n_i$ le nombre de moles du gaz i. L'air est ainsi composé d'environ 78% d'azote, de 21% d'oxygène, et de traces d'autres gaz (dont la vapeur d'eau). Dans l'air à la pression atmosphérique, fixée ici à 0,1 MPa pour simplifier la compréhension, la pression partielle de l'azote est donc de 0,078 MPa, et celle de l'oxygène de 0,021 MPa. Considérons à présent les mécanismes qui régissent les fuites de gaz. Dans notre cas, nous appellerons fuite la pénétration de gaz de l'extérieur vers l'intérieur du module, qui est sous dépression. Une fuite est la plupart du temps induite par une différence de pression entre deux volumes considérés : les gaz vont avoir tendance à passer de la zone à plus forte pression vers la zone à plus basse pression.

Considérons désormais l'application de ces principes à un module. Remplissons le module d'azote pur, à une pression absolue de 0,078 MPa, et analysons le comportement des gaz. Comme nous l'avons vu précédemment, chaque gaz se comporte comme s'il était seul à occuper le volume entier :

- la pression d'azote à l'intérieur est de 0,078 MPa, et à l'extérieur (dans l'air) de 0,078 MPa. La différence de pression est nulle, il n'y aura aucune fuite d'azote dans ce cas
- la pression d'oxygène à l'intérieur est de 0 MPa, et à l'extérieur (dans l'air) de 0,021 MPa. La différence de pression est de 0,021 MPa, et des molécules d'oxygène gazeux vont avoir tendance à pénétrer à l'intérieur du module, et donc à faire augmenter la pression interne totale de celui-ci.

Afin d'éviter une telle dégradation il est nécessaire de trouver un moyen de maintenir la dépression en oxygène à l'intérieur du module.

Un objectif de la présente invention est de fournir un module photovoltaïque, selon la revendication 1, dans lequel la dépression en oxygène de son volume interne peut être maintenue dans le temps. Un autre objectif de la présente invention est de fournir un procédé de fabrication d'un tel module, selon la revendication 10.

D'autres objectifs encore apparaîtront à la lecture de la description.

Ces objectifs sont, en tout ou en partie, remplis par la présente invention qui propose l'utilisation, selon les revendications 8 et 9, d'un getter d'oxygène dans le volume interne d'un module photovoltaïque mettant en œuvre des contacts électriques non soudés entre cellules, permettant d'absorber l'oxygène pouvant se trouver dans ce volume interne et ainsi de maintenir la dépression à un niveau suffisant pour garantir le bon fonctionnement du module.

On entend par « module mettant en œuvre des contacts électriques non soudés entre cellules » des modules dans lesquels les moyens d'interconnexion entre les cellules, par exemple des rubans de cuivre, ne sont pas soudés aux cellules (par des soudures) mais plaqués à celles-ci grâce à la pression. Le contact électrique assurant l'interconnexion des cellules est ainsi réalisé par pression et non plus par soudure.

La présente invention concerne un tel module photovoltaïque comportant un assemblage de cellules photovoltaïques disposées entre une plaque avant et une plaque arrière, des moyens d'interconnexion entre les cellules, avec des contacts entre des moyens d'interconnexion entre les cellules et les cellules non soudés, et un joint de scellement des plaques, étanche au moins partiellement aux gaz et à l'humidité et délimitant un volume interne en dépression par rapport à la pression atmosphérique, caractérisé en ce que le volume interne comprend au moins un getter d'oxygène.

On entend par getter d'oxygène un composé retenant et fixant l'oxygène. On peut également définir le getter d'oxygène comme un composé piégeur d'oxygène. Dégazeur d'oxygène et composé dégazeur d'oxygène sont également des synonymes de getter d'oxygène selon l'invention. L'oxygène piégé par le getter est l'oxygène initialement présent dans le volume interne du module et/ou l'oxygène issu de fuites dans le volume interne du module.

Le getter d'oxygène permet de maintenir une pression dans le volume interne du module permettant de garantir le fonctionnement du module, c'est-à-dire une pression à laquelle les contacts électriques, c'est-à-dire les contacts entre des moyens d'interconnexion entre les cellules et les cellules, sont maintenus sans devoir être soudés.

Le module selon l'invention peut avantageusement comprendre plusieurs getters d'oxygène de nature identique ou différente.

De nombreux tests de vieillissement accéléré sur des modules photovoltaïques sont effectués en tenant compte de toutes les variables liées à l'environnement. Cependant ces corrélations ne sont pas entièrement fiables et il est difficile de prévoir la durée de vie d'un tel module. Il est donc nécessaire de développer un système permettant de visualiser et de quantifier toute manifestation de non-étanchéité ou toute variation de la pression partielle interne d'oxygène et donc de la dépression à l'intérieur du module.

Cet objectif complémentaire est rempli en tout ou en partie par l'introduction, dans le volume interne du module de l'invention, d'un composé photoluminescent dont le spectre d'émission est modifié par la présence d'oxygène.

On entend par composé photoluminescent un composé émettant un signal dans la gamme des UV ou dans le visible, que l'on peut détecter par exemple à l'aide d'une caméra ou d'un photodétecteur en soumettant le composé à un éclairement.

Le spectre d'émission du composé photoluminescent est modifié en présence d'oxygène. De ce fait l'intensité du signal qu'il émet est fonction de la pression partielle en oxygène. Notamment, l'agent photoluminescent peut émettre un signal dont l'intensité décroit avec une augmentation de la pression partielle en oxygène. Il est alors possible de caractériser l'état interne du module, notamment la dépression et suivre son évolution dans le temps. Il est ainsi possible d'anticiper un remplacement de module avant un dysfonctionnement de toute l'installation.

Le module selon l'invention peut comprendre, en outre, au moins un composé photoluminescent.

Le composé photoluminescent peut être compris dans un bloc adhérent à l'une des surfaces internes, ou avantageusement dans un revêtement déposé par spray ou étalé comme une peinture sur au moins l'une des surfaces internes des plaques constituant le module. Le composé contient alors généralement une terre rare dont le spectre d'émission est lié à son degré d'oxydation. Un exemple de terre rare est l'europium $Eu^{2+}$ qui émet dans le bleu. En présence d'oxygène, son degré d'oxydation passe de $Eu^{2+}$ à $Eu^{3+}$ et l'intensité de son spectre d'émission diminue en fonction de la quantité d'oxygène. De tels composés sont notamment commercialisés par la société Pharmasynthèse (anciennement Panchim).

La surface du revêtement déposé doit être suffisante pour recevoir la surface d'éclairement extérieure, elle est généralement comprise entre 0,5 et 2 cm$^2$.

Selon une première variante, le composé photoluminescent est intégré au getter d'oxygène, notamment le getter d'oxygène est dopé par le composé photoluminescent.

Selon une seconde variante, le composé photoluminescent constitue le getter d'oxygène.

Pour la mesure du signal émis par le composé photoluminescent on peut utiliser un gabarit que l'on vient placer autour du module, le gabarit comprend un orifice qui peut recevoir un moyen de détection par exemple une caméra ou un photodétecteur.

L'invention concerne également l'utilisation d'au moins un getter d'oxygène, dans le volume interne d'un module photovoltaïque comportant un assemblage de cellules photovoltaïques disposées entre une plaque avant et une plaque arrière, avec des contacts entre des moyens d'interconnexion entre les cellules et les cellules non soudés, et un joint de scellement des plaques délimitant un volume interne en dépression, et notamment en dépression d'oxygène, par rapport à la pression atmosphérique pour la création et/ou le maintien de la dépression à l'intérieur de ce volume.

Il est possible d'utiliser soit le même getter d'oxygène pour les deux actions (création et maintien de la dépression) soit deux getters d'oxygène différents, l'un à cinétique rapide pour la création de la dépression et l'autre à cinétique plus lente pour le maintien de la dépression.

Dans le cas où un getter d'oxygène est utilisé uniquement pour créer la dépression à l'intérieur du module il devra être en quantité suffisante pour instaurer la dépression et il devra avoir une cinétique d'oxydation suffisamment rapide pour créer cette dépression. Cette cinétique d'oxydation rapide pourra notamment être obtenue soit par l'utilisation d'un getter à cinétique d'oxydation rapide, soit par allumage ou chauffage du getter d'oxygène par une action externe tel qu'une décharge électrique ou une activation par rayonnement laser.

Dans le cas où le getter d'oxygène est utilisé pour créer et maintenir la dépression à l'intérieur du module il devra être en quantité suffisante pour instaurer la dépression, puis pour maintenir cette dépression pendant la durée de vie du module photovoltaïque.

Dans le cas de la création de la dépression par action du getter d'oxygène, la quantité oxydable de getter d'oxygène doit permettre au minimum de consommer la totalité de l'oxygène présent dans le module. Dans le cas où l'air contient 20% d'oxygène, et où la pression dans le module fermé est de 0,1 MPa à température ambiante (25°C), la quantité d'oxygène est alors de $8.10^{-3}$ mol par litre de module. L'homme du métier peut alors déterminer la quantité de getter nécessaire pour obtenir la dépression souhaitée. Dans ce cas, la cinétique de la réaction doit également permettre la création de la dépression en oxygène rapidement, par exemple en moins d'une journée, de préférence en moins de 10 minutes, par exemple en 10 secondes. En effet, la performance électrique du module doit être mesurée sur le lieu de fabrication pour contrôler sa qualité, notamment la dépression en oxygène, et le stockage des modules avant leur mesure n'est pas aisé.

Dans le cas où le getter d'oxygène est utilisé pour maintenir la dépression, l'exemple 1 ci-dessous permet à l'homme du métier de déterminer la quantité de getter d'oxygène nécessaire pour maintenir cette dépression à une valeur souhaitée en fonction du débit de fuite observée et de la nature du getter utilisé.

L'exemple 1 donne un exemple de calcul de la quantité nécessaire de getter d'oxygène pour le maintien de la dépression en fonction du débit de fuite. L'homme du métier est donc à même de déterminer selon le débit de fuite, la quantité de getter nécessaire.

L'homme du métier est également à même de déterminer la quantité de getter d'oxygène nécessaire pour créer la dépression en fonction du volume interne du module photovoltaïque et de la pression dans le module lors de sa fermeture et avant la mise en action du getter d'oxygène.

Par exemple pour un module de volume interne 1 litre, la quantité oxydable de getter d'oxygène dans le module est au minimum de 0,01 mole, de préférence de 0,1 à 2 moles.

L'invention concerne également l'utilisation d'au moins un getter d'oxygène et d'au moins un composé photoluminescent dans le volume interne d'un module photovoltaïque comportant un assemblage de cellules photovoltaïques disposées entre une plaque avant et une plaque arrière, avec des contacts entre des moyens d'interconnexion entre les cellules et les cellules non soudés, et un joint de scellement des plaques délimitant un volume interne en dépression par rapport à la pression atmosphérique pour la création et/ou le maintien de la dépression à l'intérieur de ce volume ainsi que pour la caractérisation de la pression partielle interne d'oxygène. Comme précisé plus haut, le composé photoluminescent est sensible à la pression partielle en oxygène ; de ce fait l'intensité du signal émis par ce composé est fonction de la pression partielle en oxygène. Notamment, le composé photoluminescent présente une intensité qui décroit avec une augmentation de la pression partielle en oxygène. Il est alors possible de caractériser la pression partielle interne d'oxygène et de suivre son évolution dans le temps. Il est ainsi possible d'anticiper un remplacement de module avant un dysfonctionnement de toute l'installation.

L'invention concerne également un procédé de fabrication d'un module photovoltaïque comportant un assemblage de cellules photovoltaïques disposées entre une plaque avant et une plaque arrière, avec des contacts entre des moyens d'interconnexion entre les cellules et les cellules non soudés, et un joint de scellement des plaques délimitant un volume interne en dépression par rapport à la pression atmosphérique, comprenant les étapes suivantes :

(α) placer au moins un getter d'oxygène dans le volume interne d'un module photovoltaïque, non encore fermé, comprenant des plaques avant et arrière, un assemblage de cellules photovoltaïques, des moyens d'interconnexion entre les cellules et un joint de scellement des plaques ;
(β) créer la dépression dans le module.

Dans un premier mode de réalisation, le getter d'oxygène de l'étape (α) est utilisé pour créer la dépression ou pour créer puis maintenir la dépression ou un getter d'oxygène est utilisé pour créer la dépression et un second getter d'oxygène est utilisé pour maintenir la dépression. L'étape (β) comprend alors les étapes suivantes :

(β1) instaurer et maintenir, par tout moyen approprié, notamment à l'aide d'une seringue ou dans une enceinte, étanche aux gaz, entourant le module, une dépression contrôlée dans le module ;
(β2) fermer hermétiquement le module, par exemple par écrasement du joint
(β3) déclencher le getter pour créer la dépression.

Dans un deuxième mode de réalisation, le getter d'oxygène de l'étape (α) est utilisé pour maintenir la dépression. L'étape (β) comprend alors les étapes suivantes :

(β'1) instaurer et maintenir par tout moyen approprié autre que l'utilisation du getter d'oxygène, notamment à l'aide d'une seringue ou dans une enceinte, étanche aux gaz, entourant le module, une dépression contrôlée dans le module ;
(β'2) fermer hermétiquement le module, par exemple par écrasement du joint,

le getter d'oxygène étant utilisé uniquement pour maintenir la dépression dans le volume interne du module et pour piéger l'oxygène pénétrant dans le module.

Dans un mode de réalisation particulier, la fabrication du module peut avoir lieu dans une enceinte étanche aux gaz. L'invention concerne alors un procédé de fabrication d'un module photovoltaïque comportant un assemblage de cellules photovoltaïques disposées entre une plaque avant et une plaque arrière, avec des contacts entre les moyens d'interconnexion entre les cellules et les cellules non soudés, et un joint de scellement des plaques délimitant un volume interne en dépression par rapport à la pression atmosphérique, comprenant les étapes suivantes :

(a) placer dans une enceinte les plaques avant et arrière, un assemblage de cellules photovoltaïques, des moyens d'interconnexion entre les cellules et le joint de scellement délimitant le volume interne ;
(b) placer dans le volume interne au moins un getter d'oxygène ;
(c) fermer l'enceinte ;
(d) créer la dépression dans le volume interne.

Les étapes (a) et (b) peuvent être interverties.

L'étape (d) est suivie d'une étape (e) d'ouverture de l'enceinte.

Dans un premier mode de réalisation, le getter d'oxygène de l'étape (b) permet de créer la dépression puis de maintenir cette dépression au cours du temps ou l'un des getter d'oxygène de l'étape (b) permet de créer la dépression et un autre getter d'oxygène permet de maintenir la dépression. L'étape (d) peut être précédée d'une étape (d1), correspondant à l'instauration dans l'enceinte d'une dépression, avec une pression absolue comprise entre 0,001 et 0,1 MPa, de préférence entre 0,04 et 0,09 MPa. L'homme du métier peut choisir cette pression en fonction des effets de la variation du volume du module, notamment lors de sa fermeture et des effets de la température lors de la fabrication du module. L'étape (c) (ou (d1) si elle est appliquée) est suivie d'une étape (d2) de fermeture du module pour réaliser son étanchéité. Cette étape (d2) peut être mise en œuvre par pression des plaques et écrasement du joint de scellement. À la suite des étapes (d1) et (d2), l'étape (d) de création de la dépression est mise en œuvre par action du getter d'oxygène.

Dans un second mode de réalisation, le getter d'oxygène de l'étape (b) permet de maintenir la dépression au cours du temps et l'étape (d) de création de la dépression comprend les étapes suivantes :

(d'1) réduire la pression dans l'enceinte ;
(d'2) remplir l'enceinte d'azote ;
(d'3) abaisser la pression dans l'enceinte ;
(d'4) presser les plaques (2) et (3) pour fermer le module et réaliser l'étanchéité. Dans ce mode de réalisation le getter d'oxygène est utilisé uniquement pour maintenir la dépression dans le volume interne du module et pour piéger l'oxygène pénétrant dans le module.

De façon préférée, la pression à la fin de l'étape (d'1) est la plus faible possible afin d'éliminer le plus d'oxygène possible, par exemple de 0,001 MPa.

De façon préférée, la pression à la fin de l'étape (d'2) est d'environ 0,1 MPa, et au minimum supérieure à la pression de l'étape (d'3).

De façon préférée, la pression à la fin de l'étape (d'3) est comprise entre 0,001 et 0,1 MPa, de préférence entre 0,04 et 0,09 MPa.

Le procédé de l'invention est mis en œuvre à une température comprise entre 0 et 400°C, de préférence entre 75 et 150 °C, par exemple à 100°C.

Lors de l'étape (b), le getter d'oxygène doit être protégé contre l'oxydation afin de limiter sa détérioration préalable. De manière avantageuse, l'introduction du getter d'oxygène à l'étape (b) peut être faite sous gaz inerte ou le getter peut être introduit protégé par une enveloppe plastique qui sera retirée au dernier moment avant la fermeture du module.

D'autres avantages et caractéristiques ressortiront plus clairement de la description qui va suivre de trois modes de réalisation d'un module photovoltaïque selon l'invention, donnée à titre d'exemple non limitatif et faite en référence aux dessins annexés dans lesquels :

- la figure 1 est une coupe transversale d'un module photovoltaïque conforme à un premier mode de réalisation de l'invention ;
- la figure 2 est une coupe transversale analogue à la figure 1 pour un module photovoltaïque conforme à un deuxième mode de réalisation de l'invention ;
- la figure 3 est une coupe transversale analogue à la figure 1 pour un module photovoltaïque conforme à un troisième mode de réalisation de l'invention ;
- la figure 4 est une coupe transversale du module photovoltaïque de la figure 3 en cours de mesure de son fonctionnement ;

- la figure 5 est une coupe transversale d'un module photovoltaïque conforme à l'art antérieur pour lequel les moyens d'interconnexion entre les cellules et les cellules sont soudés.

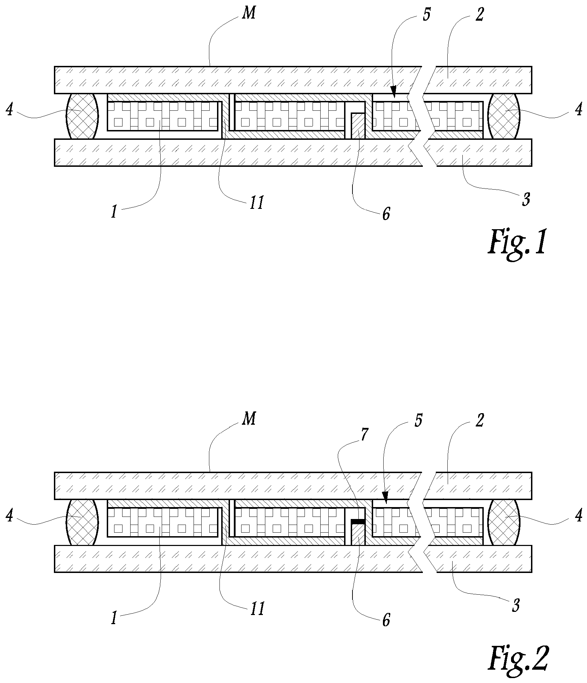

La figure 1 représente une coupe d'un module photovoltaïque M selon l'invention comprenant une plaque avant 2 destinée à être tournée vers le soleil en configuration d'utilisation du module, une plaque arrière 3, un joint de scellement 4 déposé à la périphérie des plaques 2 et 3 délimitant un volume interne 5 comprenant un assemblage de cellules photovoltaïques 1 et un getter d'oxygène 6, le volume interne 5 étant en dépression.

Le module photovoltaïque comprend également des connecteurs électriques 11 formant des moyens d'interconnexion entre les cellules, reliant les différentes cellules photovoltaïques et permettant de récupérer l'énergie électrique en sortie de module. Le module selon l'invention est un module mettant en œuvre des contacts électriques par pression, la dépression dans le volume interne du module permet de réaliser le contact entre les moyens d'interconnexion et les cellules photovoltaïques. Ainsi, les moyens d'interconnexion entre les cellules ne sont pas soudés aux cellules mais mis en contact avec lesdites cellules par action de la dépression à l'intérieur du module.

On peut distinguer deux types de getter d'oxygène, les getters d'oxygène dits chimiques qui peuvent réagir avec l'oxygène pour former des oxydes, selon un mécanisme de corrosion, et les getters d'oxygène dits physiques qui peuvent adsorber l'oxygène, notamment à leur surface selon un mécanisme de sorption ou de « mise en solution ». Selon l'invention, le getter d'oxygène permet de fixer l'oxygène contenu initialement dans le volume interne du module ou issu de fuites dans le volume intérieur et donc respectivement de créer ou de maintenir la dépression dans le module photovoltaïque.

De préférence, le getter d'oxygène fixe l'oxygène sous forme solide. En effet, dans un volume constant, le passage de l'oxygène gazeux à l'état solide s'accompagne avantageusement d'une diminution de la pression partielle en oxygène dans le volume considéré, et donc également de la pression totale.

Le choix du getter d'oxygène dépend notamment des conditions de température et de pression que va subir le module lors de sa fabrication et/ou de son utilisation. Pour les modules selon l'invention, on considère une température de fonctionnement comprise entre -40°C et 90 °C et une pression dans le volume interne du module photovoltaïque comprise entre 0,001 et 0,1 MPa, de préférence comprise entre 0,04 et 0,09 MPa. Les contacts électriques dans le module photovoltaïque selon l'invention sont assurés par la dépression dans le volume interne du module.

L'énergie libre de Gibbs, qui dépend de la température et de la pression, stipule que toute réaction chimique s'effectue avec création d'entropie. Pour une réaction donnée la variation d'énergie libre $\Delta G$ est égale à $G_{produit} - G_{réactif}$, si cette grandeur est négative, la formation du produit à partir des réactifs est thermodynamiquement possible. Il est donc nécessaire que la réaction d'oxydation du getter ait une valeur $\Delta G$ négative. Le getter d'oxygène doit par conséquent être choisi parmi tous les composés dont l'oxydation est thermodynamiquement favorable entre -40 et 150 °C. Dans le cas où le getter d'oxygène est activé par une source extérieur comme expliqué plus haut, la température haute considérée peut être plus haute que 150°C, par exemple 200°C localement au niveau du getter. L'homme du métier est à même de sélectionner de tels composés.

Le getter d'oxygène possède au moins l'une des propriétés suivantes :

- une forte affinité pour l'oxygène ;
- une cinétique d'oxydation permettant de consommer l'oxygène entrant et de ne pas être oxydé totalement lors de la fabrication du module.

Selon l'invention, le getter d'oxygène peut être constitué d'un matériau choisi parmi les métaux ou leurs alliages, les oxydes métalliques pouvant être oxydés, les composés organiques pouvant être oxydés, seuls ou en mélange.

Pour le choix des métaux ou alliages utilisables, l'homme du métier peut se référer aux diagrammes d'Ellingham qui permettent de prévoir les équilibres entre un métal et ses oxydes en fonction de la température et de la pression, le choix devant s'orienter, comme précisé plus haut, vers les équilibres à $\Delta G$ négatif.

Le getter d'oxygène peut être constitué d'un matériau choisi parmi :

- les métaux tels que le fer, le zinc, le cuivre, le cobalt, le magnésium, le calcium, le sodium, le baryum, le zirconium, l'aluminium, purs ou sous forme de leurs alliages ;
- les oxydes métalliques tels que l'oxyde de cuivre ($Cu_2O$) et l'oxyde de cobalt ($CoO$) ;
- le glucose et ses dérivés ;
- l'acide ascorbique et ses dérivés;
- le 1,2,3-triol (pyrogallol) ;
- les cycles porphyriques comprenant du ruthénium, notamment le tetraphenyl porphyranoplatinum en combinaison du ruthénium ; ou
- l'europium.

De façon préférée le getter d'oxygène est constitué d'un matériau choisi parmi le fer, le cuivre, le zinc, le titane.

De façon avantageuse, le getter d'oxygène constitue un composé photoluminescent et est choisi parmi l'europium ou les cycles porphyriques comprenant du ruthénium, notamment le tetraphenyl porphyranoplatinum en combinaison du ruthénium.

A titre de getter d'oxygène permettant de créer la dépression on peut citer, sans y être limité, les getters d'oxygène constitués de magnésium, notamment activé par une source externe, par exemple par un laser ; de titane.

A titre de getter d'oxygène permettant de maintenir la dépression on peut citer, sans y être limité les getters d'oxygène constitués de fer, notamment sous forme de poudre, de titane.

Le getter d'oxygène peut se trouver sous toute forme, notamment sous forme de fil ; de ruban ; de poudre ; de bloc ; il peut également être compris dans une matrice, notamment matrice organique perméable à l'oxygène, par exemple matrice acrylique, formant ainsi un revêtement, notamment liquide, qui peut être déposée sur au moins l'une des parois internes des plaques du module.

Dans le cas où le getter d'oxygène est l'europium ou un cycle porphyrique comprenant du ruthénium, il est avantageusement intégré dans un revêtement déposé sur au moins l'une des parois internes des plaques du module.

De façon avantageuse, le getter d'oxygène possède une surface spécifique élevée, de 50 à 800 m$^2$/kg, de préférence de 100 à 500 m$^2$/kg, par exemple voisine de 150 m$^2$/kg. De façon avantageuse, le getter d'oxygène est alors sous forme de poudre, de ruban ou de bloc poreux.

Certains getters d'oxygène, lorsqu'ils s'oxydent forment une couche d'oxygène natif imperméable à l'oxygène empêchant ou ralentissant l'oxydation de la partie résiduelle non oxydée du getter d'oxygène. Si de tels getters d'oxygène sont utilisés il convient de prévoir une quantité suffisante de getter d'oxygène et/ou une mise en forme du getter d'oxygène avec une grande surface spécifique, par exemple un getter d'oxygène sous forme poreuse.

Dans le cas ou le getter d'oxygène est sous forme de fil, de ruban, de poudre ou de bloc, l'étape (b) comprend le dépôt du getter d'oxygène contre l'une des plaques formant le module. De préférence, le getter d'oxygène est collé sur l'une de ces plaques.

Dans le cas ou le getter d'oxygène est compris dans une matrice et notamment appliqué sous forme d'un revêtement, le procédé de l'invention comprend une étape préalable, avant l'étape (a), de dépôt d'une couche de revêtement comprenant le getter d'oxygène sur au moins l'une des surfaces internes des plaques formant le module.

De façon avantageuse, il est possible d'ajouter au getter d'oxygène un agent activant tel que le chlorure de sodium, le chlorure de calcium, le chlorure de fer ou le carbonate de sodium.

Le joint de scellement est présent en périphérie des plaques.

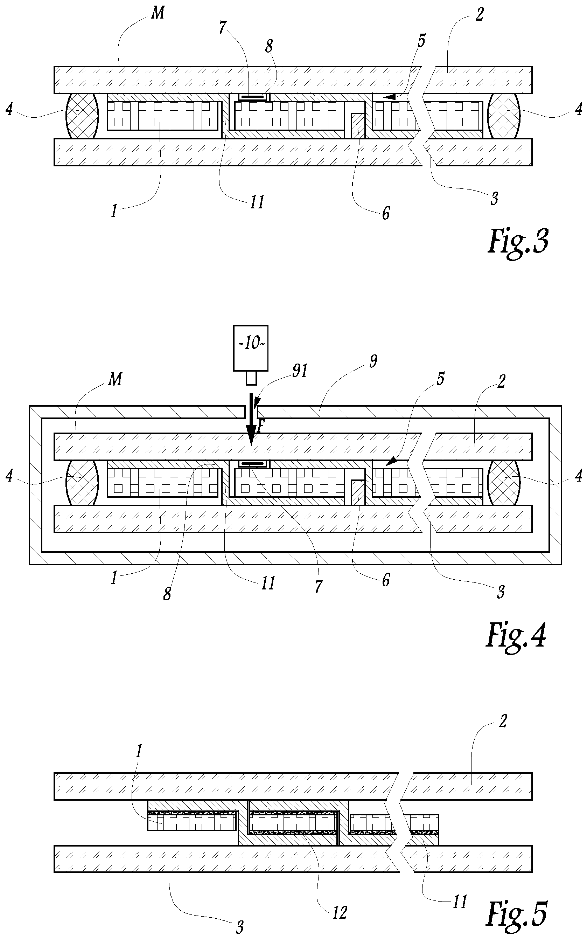

Dans les deuxièmes et troisièmes modes de réalisation représentés respectivement aux figures 2 et 3, les éléments 1, 2, 3, 4, 5, 6 et 11 sont identiques à ceux du premier mode de réalisation.

Dans le mode de réalisation de la figure 2, le getter d'oxygène 6 comprend un composé photoluminescent 7. Dans le mode de réalisation de la figure 3, le module M comprend, outre le getter d'oxygène 6 un revêtement 8 comprenant un composé photoluminescent 7 sur au moins une partie de la surface interne de la plaque 2.

Le composé photoluminescent peut être choisi parmi les terres rares, les métaux de transition, les molécules photoluminescentes.

De façon préférée, les terres rares sont choisis parmi l'europium, notamment Eu$^{2+}$, Eu$^{3+}$ ; le terbium, notamment Tb$^{3+}$.

Une variante consiste à utiliser des métaux de transition sont choisis parmi le cobalt, notamment Co$^{2+}$, Co$^{3+}$.

Une variante consiste à utiliser des molécules photoluminescentes choisies parmi des dérivés de cycle porphyrique comprenant du platine ou du ruthénium, par exemple tetraphényl porphinatoplatinum (ptPP).

Lorsque le composé photoluminescent est compris dans un bloc ou un revêtement, ce bloc ou revêtement est notamment une matrice polymérique organique. La matrice polymérique organique peut être une matrice polymérique perméable à l'oxygène ; par exemple une matrice acrylique, notamment à base de méthacrylate.

De façon préférée la quantité de composé photoluminescent est comprise entre 0,5 mg et 3 mg, par exemple 1 mg.

La figure 4 est une coupe transversale du module de la figure 3 en cours de mesure de son vieillissement, un boitier 9 permet de maintenir l'obscurité afin de détecter le signal émis par l'agent luminophore 7 par un moyen de détection 10, tel qu'une caméra qui vise le revêtement 8 à travers une ouverture 91 du boitier 9, comme représenté par la flèche F.

La figure 5 est une coupe transversale d'un module photovoltaïque conforme à l'art antérieur comprenant une plaque avant 2 destinée à être tournée vers le soleil en configuration d'utilisation du module, une plaque arrière 3, et un assemblage de cellules photovoltaïques 1, étant typiquement encapsulées dans un matériau transparent, par exemple l'EVA (Éthyl Vynil Acétate). Le module photovoltaïque comprend également des connecteurs électriques 11 formant des moyens d'interconnexion entre les cellules et reliant les différentes cellules photovoltaïques par l'intermédiaire d'une soudure 12.

Le module selon l'invention peut être tout module photovoltaïque, présentant un volume interne rempli de gaz, connu de l'homme du métier, notamment un module à concentration, un module utilisant une technologie couche mince, un module utilisant des cellules à contacts arrière ou un module utilisant des cellules en silicium cristallin.

L'invention va maintenant être décrite à l'aide d'exemples, ceux-ci étant donnés à titre d'illustration sans pour autant être limitatifs.

Exemple 1 : Étude quantitative de la quantité de getter nécessaire

La quantité de getter d'oxygène doit être suffisante pour permettre de consommer la quantité d'oxygène susceptible de pénétrer dans le module.

Notons $D_{O2}$ le taux de pénétration d'oxygène dans le module (en mol.min$^{-1}$), T la durée de vie d'un module (en minutes) et $n_{O2}$ la quantité d'oxygène devant être absorbée par le getter (en mol). Nous avons la relation :

$$n_{O2} = D_{O2} . T$$

Nous considérons ici un getter d'oxygène A s'oxydant selon la réaction suivante :

$$\alpha A + \beta O_2 \rightarrow A_\alpha O_{2\beta}$$

$\alpha$ et $\beta$ sont les coefficients stœchiométriques de cette réaction. En prenant en compte les caractéristiques de l'oxyde formé par le getter d'oxygène A (notamment si une couche d'oxyde imperméable à l'oxygène se forme), nous pouvons définir une masse oxydable de A, dont la totalité est apte à réagir avec l'oxygène suivant la réaction ci-dessus. Les caractéristiques de A sont alors les suivantes :

- Masse molaire : $M_A$ (g.mol$^{-1}$)
- Masse oxydable : $m_A$ (g)
- Quantité de matière oxydable : $n_A$ (mol)

La quantité de getter d'oxygène nécessaire est donc :

$$n_A = n_{O2} . \alpha/\beta = D_{O2} . T . \alpha/\beta$$

Et sa masse oxydable nécessaire :

$$m_A = n_A . M_A = D_{O2} . T. \alpha/\beta . M_A$$

Ainsi dans les conditions suivantes :

- Débit de fuite : $D_{O2} = 10^{-8}$ mol.min$^{-1}$
- T = 30 ans = $1{,}58.10^7$ minutes
- getter : Fer (Fe) s'oxyde en $Fe_2O_3$
- Réaction d'oxydation : $2Fe + 3/2\ O_2 \rightarrow Fe_2O_3$ ($\alpha$=2 et $\beta$=3/2)
- Masse molaire du fer : $M_A = 56$ g.mol$^{-1}$

La masse oxydable minimale de getter d'oxygène nécessaire est donc : $m_{Fe} = 11{,}7$ g

Exemple 2 : Cinétique de la réaction d'oxydation.

Dans l'exemple 1, le débit de fuite considéré est $D_{O2} = 10^{-8}$ mol.min$^{-1}$.

Si l'on souhaite consommer la totalité de l'oxygène pénétrant dans le module avec ce débit de fuite, et si l'on considère que la quantité de matière oxydable du getter est en excès, il faut que la cinétique de la réaction soit au moins aussi rapide que l'apport d'oxygène par la fuite considérée.

Reprenons la réaction de l'exemple 1 : $\alpha A + \beta O_2 \rightarrow A_\alpha O_{2\beta}$

Lorsque la réaction a lieu, les réactifs A et $O_2$ disparaissent alors que le produit $A_\alpha O_{2\beta}$ se forme. On définit alors l'avancement $\xi$ de la réaction :

$$d\xi = -\frac{dn_A}{\alpha} = -\frac{dn_B}{\beta} = dn_{A_\alpha B_\beta}$$

En notant t le temps, on définit la vitesse molaire de réaction $\xi$ dont l'unité est la mol.s$^{-1}$ ou la mol.min$^{-1}$ :

$$\dot{\xi} = \frac{d\xi}{dt} = -\frac{1}{\alpha}\frac{dn_A}{dt}$$

Pour que la réaction compense au moins la fuite, on doit alors respecter la relation suivante :

$$-\frac{dn_{o_2}}{dt} \geq D_{O_2}$$

Appliquée à la réaction de l'exemple 1, nous avons :

$$\dot{\xi} \geq \frac{1}{\alpha}.D_{O_2}$$

La condition à respecter pour la vitesse théorique de la réaction de l'oxydation du fer est donc :

$$\dot{\xi} \geq \frac{1}{2}.D_{O_2} \text{ soit } \dot{\xi} \geq 5.10^{-9}mol.\min^{-1}$$

Ces exemples s'appliquent aux trois modes de réalisation représentés sur les figures.

Les caractéristiques techniques des modes de réalisation et variantes envisagées ci-dessus peuvent être combinées entre elles.

**Revendications**

1. Module photovoltaïque (M) comportant un assemblage de cellules photovoltaïques (1) disposées entre une plaque avant (2) et une plaque arrière (3), avec des contacts entre des moyens d'interconnexion entre les cellules (11) et les cellules non soudés, et un joint de scellement (4) des plaques (2,3), étanche au moins partiellement aux gaz et à l'humidité et délimitant un volume interne (5) en dépression par rapport à la pression atmosphérique, la dépression dans le volume interne du module permettant de réaliser le contact entre les moyens d'interconnexion et les cellules photovoltaïques, **caractérisé en ce que** le volume interne comprend au moins un getter d'oxygène (6).

2. Module selon la revendication 1 **caractérisé en ce que** le getter d'oxygène (6) est constitué d'un matériau choisi parmi les métaux ou leurs alliages, les oxydes métalliques pouvant être oxydés, les composés organiques pouvant être oxydés, seul ou en mélange.

3. Module selon les revendications 1 ou 2 **caractérisé en ce que** le getter d'oxygène (6) est constitué d'un matériau choisi parmi le fer, le zinc, le cuivre, le cobalt, le magnésium, le calcium, le sodium, le baryum, le zirconium, l'aluminium, le titane, purs, sous forme de leurs alliages ; l'oxyde de cuivre ($Cu_2O$), l'oxyde de cobalt (CoO), le glucose et ses dérivés ; l'acide ascorbique et ses dérivés ; le 1,2,3-triol (pyrogallol) ; les cycles porphyriques comprenant du ruthénium, notamment le tetraphenyl porphyranoplatinum en combinaison du ruthénium ; ou l'europium.

4. Module selon les revendications 1 à 3 **caractérisé en ce que** le getter d'oxygène (6) présente une surface spécifique de 50 à 800 m$^2$/kg.

5. Module selon les revendications 1 à 4 **caractérisé en ce qu'**il comprend en outre au moins un composé photoluminescent (7) dont le spectre d'émission est modifié en présence d'oxygène.

6. Module selon la revendication 5 **caractérisé en ce que** le composé photoluminescent (7) est intégré au getter d'oxygène (6), constitue le getter d'oxygène (6) ou est compris dans un bloc (8) adhérant à au moins l'une des surfaces internes des plaques (2,3), ou dans un revêtement (8) déposé par spray ou étalé sur au moins l'une des surfaces internes des plaques (2,3)

7. Module selon les revendications 5 ou 6 **caractérisé en ce que** le composé photoluminescent (7) est choisi parmi les terres rares, les métaux de transition et les molécules organique photolumiscentes.

8. Utilisation d'au moins un getter d'oxygène (6) dans le volume interne (5) d'un module photovoltaïque comportant un assemblage de cellules photovoltaïques (1) disposées entre une plaque avant (2) et une plaque arrière (3) , avec des contacts entre des moyens d'interconnexion entre les cellules (11) et les cellules non soudés, et un joint de scellement (4) des plaques délimitant le volume interne (5), pour la création et/ou le maintien de la dépression à l'intérieur de ce volume (5), la dépression dans le volume interne du module permettant de réaliser le contact entre les moyens d'interconnexion et les cellules photovoltaïques.

9. Utilisation d'au moins un getter d'oxygène (6) et d'au moins un composé photoluminescent (7) dans le volume interne (5) d'un module photovoltaïque comportant un assemblage de cellules photovoltaïques (1) disposées entre une plaque avant (2) et une plaque arrière (3) , avec des contacts entre des moyens d'interconnexion entre les cellules (11) et les cellules non soudés, et un joint de scellement (4) des plaques délimitant le volume interne, pour la création et/ou le maintien de la dépression à l'intérieur de ce volume ainsi que pour la caractérisation de la pression partielle interne d'oxygène du module, la dépression dans le volume interne du module permettant de réaliser le contact entre les moyens d'interconnexion et les cellules photovoltaïques.

10. Procédé de fabrication d'un module photovoltaïque comportant un assemblage de cellules photovoltaïques disposées entre une plaque avant et une plaque arrière, avec des contacts entre des moyens d'interconnexion entre les cellules et les cellules non soudés, et un joint de scellement des plaques délimitant un volume interne en dépression par rapport à la pression atmosphérique, la dépression dans le volume interne du module permettant de réaliser le contact entre les moyens d'interconnexion et les cellules photovoltaïques, le procédé comprenant les étapes suivantes :

    ($\alpha$) placer au moins un getter d'oxygène dans le volume interne d'un module photovoltaïque, non encore fermé, comprenant des plaques avant et arrière, un assemblage de cellules photovoltaïques, des moyens d'interconnexion entre les cellules et un joint de scellement des plaques ;
    ($\beta$) créer la dépression dans le module.

11. Procédé selon la revendication 10, **caractérisé en ce que** le getter d'oxygène est utilisé pour créer la dépression ou pour créer puis maintenir la dépression ou un getter est utilisé pour créer la dépression et un second getter est utilisé pour maintenir la dépression et l'étape ($\beta$) comprend les étapes suivantes :

    ($\beta$1) instaurer et maintenir une dépression contrôlée dans le module ;
    ($\beta$2) fermer hermétiquement le module ;
    ($\beta$3) déclencher le getter pour créer la dépression.

12. Procédé selon la revendication 10, **caractérisé en ce que** le getter d'oxygène est utilisé pour maintenir la dépression et l'étape ($\beta$) comprend les étapes suivantes :

    ($\beta$'1) instaurer et maintenir une dépression contrôlée dans le module par un moyen autre que l'utilisation du getter d'oxygène ;
    ($\beta$'2) fermer hermétiquement le module ;
    le getter d'oxygène étant utilisé uniquement pour maintenir la dépression dans le volume interne du module et pour piéger l'oxygène pénétrant dans le module.

**Patentansprüche**

1. Photovoltaisches Modul (M) mit einer Anordnung von photovoltaischen Zellen (1), die zwischen einer vorderen Platte (2) und einer hinteren Platte (3) angeordnet sind, mit Kontakten zwischen Verbindungsmitteln zwischen den Zellen (11) und den nicht gelöteten Zellen, und einer Abdichtung (4) zwischen den Platten (2,3), die zumindest teilweise gas- und feuchtigkeitsdicht ist und ein Innenvolumen (5) abgrenzt, das im Vergleich zum Atmosphärendruck einen Unterdruck aufweist, wobei der Unterdruck im Innenvolumen des Moduls den Kontakt zwischen den Verbindungsmitteln und den photovoltaischen Zellen ermöglicht, **dadurch gekennzeichnet, dass** das Innenvolumen mindestens einen Sauerstoffgetter (6) umfasst.

2. Modul nach Anspruch 1, **dadurch gekennzeichnet, dass** der Sauerstoffgetter (6) aus einem Material besteht, das aus Metallen oder deren Legierungen, oxidierbaren Metalloxiden, oxidierbaren organischen Verbindungen, allein oder in Mischung, ausgewählt wird.

3. Modul nach Ansprüche 1 oder 2, **dadurch gekennzeichnet, dass** der Sauerstoffgetter (6) aus einem Material besteht, das aus Eisen, Zink, Kupfer, Kobalt, Magnesium, Kalzium, Natrium, Barium, Zirkonium, Aluminium, Titan, rein, in Form ihrer Legierungen; Kupferoxid ($Cu_2O$), Kobaltoxid (CoO), Glucose und ihre Derivate; Ascorbinsäure und ihre Derivate; 1,2,3-Triol (Pyrogallol); Ruthenium enthaltende Porphyr-Zyklen, vor allem Tetraphenyl Porphyranoplatinum in Kombination mit Ruthenium; oder Europium, ausgewählt wird.

4. Modul nach Ansprüche 1 bis 3, **dadurch gekennzeichnet, dass** der Sauerstoffgetter (6) eine spezifische Oberfläche von 50 bis 800 $m^2$/kg aufweist.

5. Modul nach Ansprüche 1 bis 4, **dadurch gekennzeichnet, dass** es darüber hinaus mindestens eine photolumineszente Verbindung (7) enthält, deren Emissionsspektrum in Gegenwart von Sauerstoff verändert wird.

6. Modul nach Anspruch 5, **dadurch gekennzeichnet, dass** die photolumineszente Verbindung (7) mit dem Sauerstoffgetter (6) integriert ist, den Sauerstoffgetter (6) bildet oder in einem Block (8), der an mindestens einer der Innenflächen der Platten (2,3) haftet, oder in einer Beschichtung (8), die an mindestens einer der Innenflächen der Platten (2,3) aufgesprüht oder aufgetragen ist, enthalten ist.

7. Modul nach Ansprüche 5 oder 6, **dadurch gekennzeichnet, dass** die photolumineszente Verbindung (7) aus seltenen Erden, Übergangsmetallen und photolumineszenten organischen Molekülen ausgewählt ist.

8. Verwendung von mindestens einem Sauerstoffgetter (6) im Innenvolumen (5) eines photovoltaischen Moduls, das eine Anordnung von photovoltaischen Zellen (1) umfasst, die zwischen einer vorderen Platte (2) und einer hinteren Platte (3) angeordnet sind, mit Kontakten zwischen Verbindungsmitteln zwischen den Zellen (11) und den nicht gelöteten Zellen und einer Abdichtung (4) der Platten, die das Innenvolumen (5) begrenzen um den Unterdruck im Inneren dieses Volumens (5) zu erzeugen und/oder aufrechtzuerhalten, wobei der Unterdruck im Innenvolumen des Moduls die Kontaktierung zwischen den Verbindungsmitteln und den photovoltaischen Zellen ermöglicht.

9. Verwendung von mindestens einem Sauerstoffgetter (6) und mindestens einer photolumineszenten Verbindung (7) im Innenvolumen (5) eines photovoltaischen Moduls, das eine Anordnung von photovoltaischen Zellen (1) umfasst, die zwischen einer vorderen Platte (2) und einer hinteren Platte (3) angeordnet sind, mit Kontakten zwischen Verbindungsmitteln zwischen den Zellen (11) und den nicht verlöteten Zellen, und eine Abdichtung (4) der Platten, die das Innenvolumen begrenzen, um den Unterdruck im Inneren dieses Volumens zu erzeugen und/oder aufrechtzuerhalten sowie um den internen Sauerstoffpartialdruck des Moduls zu charakterisieren, wobei der Unterdruck im Innenvolumen des Moduls die Kontaktherstellung zwischen den Verbindungsmitteln und den photovoltaischen Zellen ermöglicht.

10. Verfahren zur Herstellung eines photovoltaischen Moduls, das eine Anordnung von photovoltaischen Zellen umfasst, die zwischen einer vorderen Platte und einer hinteren Platte angeordnet sind, mit Kontakten zwischen Verbindungsmitteln zwischen den Zellen und den nicht gelöteten Zellen und einer Abdichtung zwischen den Platten, die ein Innenvolumen unter Unterdruck bezüglich des Atmosphärendrucks abgrenzt, wobei der Unterdruck im Innenvolumen des Moduls es ermöglicht, einen Kontakt zwischen den Verbindungsmitteln und den photovoltaischen Zellen herzustellen, wobei das Verfahren die folgenden Schritte umfasst:

   (α) Einbringen mindestens eines Sauerstoffgetters in das Innenvolumen eines noch nicht geschlossenen Photovoltaikmoduls, das vordere und hintere Platten, eine Anordnung von photovoltaischen Zellen, Verbindungsmittel zwischen den Zellen und eine Plattenabdichtung umfasst;

(β) den Unterdruck im Modul erzeugen.

11. Verfahren nach Anspruch 10, **dadurch gekennzeichnet, dass** der Sauerstoffgetter zur Erzeugung des Unterdrucks oder zur Erzeugung und anschließenden Aufrechterhaltung des Unterdrucks verwendet wird oder ein Getter zur Erzeugung des Unterdrucks und ein zweiter Getter zur Aufrechterhaltung des Unterdrucks verwendet wird und Schritt (β) die folgenden Schritte umfasst:

(β1) einen kontrollierten Unterdruck im Modul herstellen und aufrechterhalten;

(β2) das Modul hermetisch verschließen;

(β3) den Getter auslösen, um den Unterdruck zu erzeugen.

12. Verfahren nach Anspruch 10, **dadurch gekennzeichnet, dass** der Sauerstoffgetter zur Aufrechterhaltung des Unterdrucks verwendet wird und Schritt (β) die folgenden Schritte umfasst:

(β'1) Erzeugung und Aufrechterhaltung eines kontrollierten Unterdrucks im Modul durch andere Mittel als den Einsatz des Sauerstoffgetters;

(β'2) das Modul hermetisch verschließen;

der Sauerstoffgetter dient nur zur Aufrechterhaltung des Unterdrucks im Innenvolumen des Moduls und zum Auffangen des in das Modul eintretenden Sauerstoffs.

**Claims**

1. A photovoltaic module (M) including an assembly of photovoltaic cells (1) disposed between a front plate (2) and a rear plate (3), with contacts between interconnection means between the cells (11) and the unwelded cells, and a joint (4) for sealing the plates (2, 3), at least partially gas and moisture tight and delimiting an internal volume (5) under vacuum pressure relative to the atmospheric pressure, the vacuum pressure in the internal volume of the module allowing making the contact between the interconnection means and the photovoltaic cells, **characterised in that** the internal volume comprises at least one oxygen getter (6).

2. The module according to claim 1, **characterised in that** the oxygen getter (6) consists of a material selected from metals or the alloys thereof, the metal oxides which can be oxidised, the organic compounds which can be oxidised, alone or in a mixture.

3. The module according to claims 1 or 2, **characterised in that** the oxygen getter (6) consists of a material selected from pure iron, zinc, copper, cobalt, magnesium, calcium, sodium, barium, zirconium, aluminium, titanium, in the form of the alloys thereof; copper oxide ($Cu_2O$), cobalt oxide (CoO), glucose and the derivatives thereof; ascorbic acid and the derivatives thereof; 1,2,3-triol (pyrogallol); porphyric rings comprising ruthenium, in particular tetraphenyl porphyranoplatinum in combination with ruthenium; or europium.

4. The module according to claims 1 to 3, **characterised in that** the oxygen getter (6) has a specific surface area of 50 to 800 $m^2$/kg.

5. The module according to claims 1 to 4, **characterised in that** it further comprises at least one photoluminescent compound (7) whose emission spectrum is modified in the presence of oxygen.

6. The module according to claim 5, **characterised in that** the photoluminescent compound (7) is integrated into the oxygen getter (6), constitutes the oxygen getter (6) or is comprised in a block (8) adhering to at least one of the inner surfaces of the plates (2, 3), or in a coating (8) spray deposited or spread on at least one of the inner surfaces of the plates (2, 3).

7. The module according to claims 5 or 6, **characterised in that** the photoluminescent compound (7) is selected from rare earths, transition metals and photoluminescent organic molecules.

8. A use of at least one oxygen getter (6) in the internal volume (5) of photovoltaic module including an assembly of photovoltaic cells (1) disposed between a front plate (2) and a rear plate (3), with contacts between interconnection means between the cells (11) and the unwelded cells, and a joint (4) for sealing the plates delimiting the internal volume (5), for creating and/or maintaining the vacuum pressure inside this volume (5), the vacuum pressure in the internal volume of the module allowing making the contact between the interconnection means and the photovoltaic cells.

9. The use of at least one oxygen getter (6) and at least one photoluminescent compound (7) in the internal volume (5) of a photovoltaic module including an assembly of photovoltaic cells (1) disposed between a front plate (2) and a rear plate (3), with contacts between interconnection means between the cells (11) and the unwelded cells, and a joint (4) for sealing the plates delimiting the internal volume, for creating and/or maintaining the vacuum pressure inside this volume as well as for the characterisation of the internal partial pressure of oxygen of the module, the vacuum pressure in the internal volume of the module allowing making the contact between the interconnection means and the photovoltaic cells.

10. A method for manufacturing a photovoltaic module including an assembly of photovoltaic cells disposed between a front plate and a rear plate, with contacts between interconnection means between the cells and the unwelded cells, and a joint for sealing the plates delimiting an internal volume under vacuum pressure relative to the atmospheric pressure, the vacuum pressure in the internal volume of the module allowing making the contact between the interconnection means and the photovoltaic cells, the method comprising the following steps :

   ($\alpha$) placing at least one oxygen getter in the internal volume of a photovoltaic module, not yet closed, comprising front and rear plates, an assembly of photovoltaic cells,
   interconnection means between the cells and a joint for sealing the plates;
   ($\beta$) creating the vacuum pressure in the module.

11. The method according to claim 10, **characterised in that** the oxygen getter is used to create the vacuum pressure or to create then maintain the vacuum pressure or a getter is used to create the vacuum pressure and a second getter is used to maintain the vacuum pressure and step ($\beta$) comprises the following steps:

   ($\beta$1) establishing and maintaining a controlled vacuum pressure in the module;
   ($\beta$2) hermetically closing the module;
   ($\beta$3) triggering the getter to create the vacuum pressure.

12. The method according to claim 10, **characterised in that** the oxygen getter is used to maintain the vacuum pressure and step ($\beta$) comprises the following steps:

   ($\beta$'1) establishing and maintaining a controlled vacuum pressure in the module by means other than using the oxygen getter;
   ($\beta$'2) hermetically closing the module;
   the oxygen getter being used only to maintain the vacuum pressure in the internal volume of the module and to trap the oxygen entering the module.

Fig.1

Fig.2

Fig.3

Fig.4

Fig.5

**EP 2 647 058 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2004095586 A
- FR 2862427 A1